# EUROPEAN PATENT SPECIFICATION

(11) **EP 1 884 306 B1**
(45) Date of publication and mention of the grant of the patent: **03.03.2010**
(21) Application number: 07113520.6
(22) Date of filing: 31.07.2007
(51) Int. Cl.: B23K 9/04, B23K 26/34, F01D 5/00

(54) **Hybrid welding repair of gas turbine superalloy components**
Reparatur von Gasturbinenbauteilen aus Superlegierungen durch Hybridschweißen
Réparation par soudure hybride de composants de turbine à gaz en superalliage

(30) Priority: 01.08.2006 US 498290
(43) Date of publication of application: 06.02.2008
(73) Proprietor: Honeywell International Inc., Morristown NJ 07960 (US)
(72) Inventor: Hu, Yiping, Greer, NJ 29650 (US); Taylor, Clyde R., Laurens, SC 29360 (US); Bye, Richard L., Morristown, NJ 07960 (US)
(74) Representative: Haley, Stephen

(56) References cited:
- WO-A-00/74887
- US-A- 4 212 900
- US-A- 4 940 390

## Description

The present invention relates to gas turbine engines and, more particularly, to methods for repairing superalloy components of the gas turbine engines.

Gas turbine engines, such as turbofan gas turbine engines, may be used to power various types of vehicles and systems, such as, for example, aircrafts. Typically, these engines include turbine blades (or airfoils) that are impinged by high-energy compressed air that causes a turbine of the engine to rotate at a high speed. Consequently, the blades are subjected to high heat and stress loadings which, over time, may degrade their structural integrity.

To improve structural integrity and durability of gas turbine engines, the turbine blades have been fabricated from high-temperature materials such as nickel-based and cobalt-based superalloys, and can include internal cooling systems formed therein that maintain the temperatures thereof within superalloy tolerating limits. Typically, the blades are air cooled using, for example, bleed air from a compressor section of the engine. The air may enter near the blade root, and then flow through a cooling circuit formed inside the turbine blade. The cooling circuit typically consists of a series of connected channels that form serpentine paths, which increase the cooling effectiveness by extending the length of the air flow path. In some cooling circuits, turbulator bumps, full or half pin fins, or other types of structured rougheners extend partially into the flow path to augment heat transfer from the blade to the cooling air. The air exits the blade via small cooling holes that are typically formed on airfoils and a trailing edge of the blade.

Although nickel-based and cobalt-based superalloys have good high temperature properties and many other advantages, they may be susceptible to corrosion, oxidation, thermal fatigue and erosion damage in the high temperature environment of turbine engine operation. Because the blades may be relatively costly to manufacture, the damaged blades are preferably repaired. One conventional repair method involves laser welding material onto a degraded section of the blade and machining the welded blade to its original configuration (see US-A-940 390). However, blades having internal cooling channels are already relatively thin-walled; thus, laser welding in the thin-wall airfoils may cause further damage thereto. Additionally, because laser welding melts a shallow surface of the blade to form metallurgical bonding, the repaired blade walls that make up the internal cooling channel may become misshapen. Consequently, the airflow through the flowpath may be greatly affected. Another repair method, disclosed in U.S. Patent No. 6,417,477, involves the use of electro-spark deposition to build up a repair layer on a damaged component. Although electro-spark deposition is a low heat process that allows material to be deposited with negligible damage to the original blade and with little danger of affecting the cooling channels, deposits made with the process tend to contain high levels of defects such as porosity that can affect mechanical properties. It is also a very slow process, impacting practicality for widespread use.

Hence, there is a need for a method of repairing damaged thin-walled blades having an internal cooling circuit without causing further damage thereto. Specifically, it is desirable for the method to allow the shape of a blade internal cooling circuit to be maintained. It would be desirable for the method to be simple and relatively inexpensive to perform.

The present invention provides methods of repairing a degraded section of a turbine blade, the turbine blade comprising a base material.

In one embodiment, and by way of example only, the method includes the step of electro-spark depositing a first material on the degraded section of the turbine blade to form an intermediate layer thereon, where the first material comprises a material that is substantially similarly or is more corrosion and oxidation resistant than the base material. Next, a second material is laser welded onto the intermediate layer to form a repaired section.

In another embodiment, and by way of example only, the method includes electro-spark depositing a first material on the turbine blade degraded section to form an intermediate layer. Then a repaired section is formed from the intermediate layer by welding a second material on to the intermediate layer using a hand-held laser powder fusion weld. Next, the repaired section of the turbine blade is machined to an original configuration. Optionally, the turbine blade is then coated, heat treated and finally inspected.

In still another embodiment, the method includes grounding the turbine blade. Then the turbine blade is contacted with an electrode comprising a first material. A current is passed between the electrode and the degraded section of the grounded blade to form an intermediate layer. Next, a repaired section is formed from the intermediate layer by welding a second material onto the intermediate layer with a hand held laser powder fusion weld. The repaired section of the turbine blade is machined to an original configuration. Optionally, the blade is then coated, heat treated and finally inspected.

Other independent features and advantages of the preferred method will become apparent from the following detailed description, taken in conjunction with the accompanying drawings which illustrate, by way of example, the principles of the invention.

### IN THE DRAWINGS

FIG. 1 is an isometric view of an exemplary damaged aircraft jet engine turbine rotor blade; and

FIG. 2 is a cross section view of a portion of the blade shown in FIG. 1;

FIG. 3 is another cross section view of the blade taken along line 3-3 shown in FIG. 2

FIG. 4 is a flow chart depicting a method for repairing the damaged gas turbine engine turbine rotor blade.

The following detailed description of the invention is merely exemplary in nature and is not intended to limit the invention or the application and uses of the invention. Furthermore, there is no intention to be bound by any theory presented in the preceding background of the invention or the following detailed description of the invention.

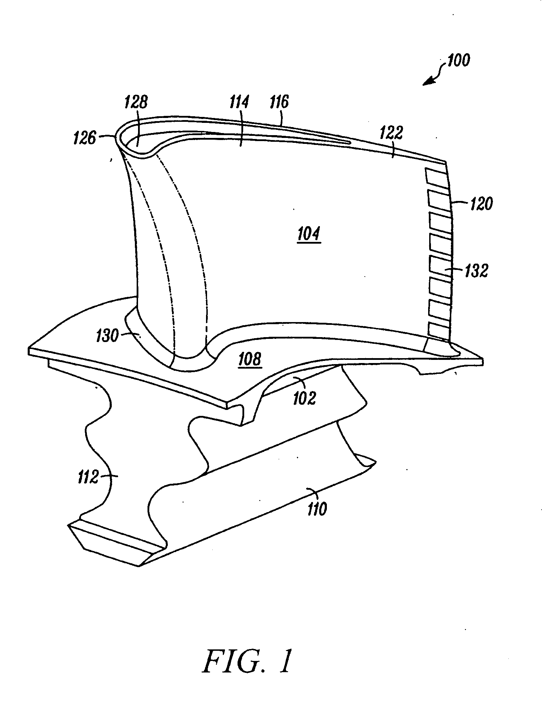

FIG. 1 illustrates an exemplary aircraft jet engine turbine rotor blade 100. The blade 100 is preferably made of a base material and may include various coatings thereon for protection thereof. In one exemplary embodiment, the base material is a nickel-based superalloy, and may be, for example, such as SC180, MarM247, C101, IN713, or IN738. It will be appreciated that other suitable materials may alternatively be used. The protective coatings may be one of numerous suitable materials that are corrosive and oxidation resistant, such as environment-resistant diffusion aluminide and/or MCrAlY overlay coatings.

The blade 100 depicted in FIG. 1 includes a shank 102 and an airfoil 104. The shank 102 has a platform 108 and a root 110. The platform 108 is configured to radially contain turbine airflow. The root 110 provides an area in which a firtree 112 is machined. The firtree 112 is used to attach the blade 100 to a turbine rotor disc (not illustrated). It will be appreciated that in other embodiments, any one of numerous other shapes suitable for attaching the blade 100 to the turbine disk, may be alternatively machined therein. The airfoil 104 has two outer walls 114, 116 each having outer surfaces that together define an airfoil shape. The airfoil shape includes a leading edge 118, a trailing edge 120, a pressure side 122 along the first outer wall 114, a suction side 126 along the second outer wall 116, a blade tip 128, and an airfoil platform fillet 130. The trailing edge 120 includes a plurality of cooling openings 132 formed therein.

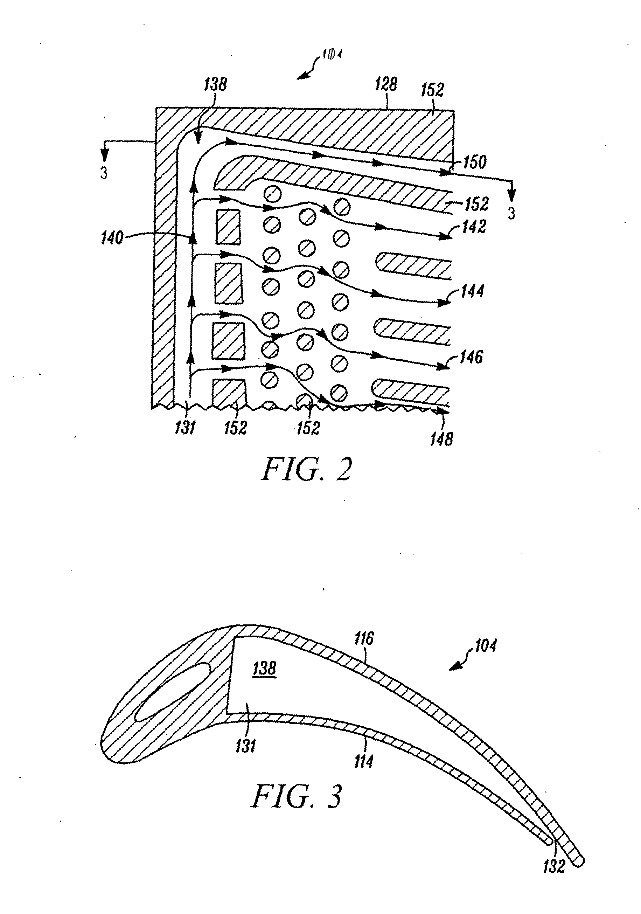

With reference now to FIGs. 2 and 3, cross sections of a portion of the airfoil 104 are shown. The airfoil 104 has a plenum 131 that includes an internal cooling circuit 138 which communicates with the plurality of cooling openings 132. The internal cooling circuit 138 is made up of a plurality of serpentine flowpaths 140, 142, 144, 146, 148, 150 that are defined, in part, by the airfoil outer walls 114, 116, and other structures 152 that extend inwardly therefrom. At least one of the flowpaths 140-150, preferably the flowpath 150 adjacent the blade tip 128, is defined by structures 152. The structures 152 may be any one of numerous suitable structures capable of enhancing heat transfer from the airfoil walls 114, 116 to the cooling air traveling along the flowpath 150. It will be appreciated that the flow paths may be disposed in any suitable predetermined pattern, and may include any appropriate number. Moreover, although the flowpaths 140-150 are shown in FIG. 2 as communicating with each other, the flow paths in other embodiments alternatively may not communicate with each other.

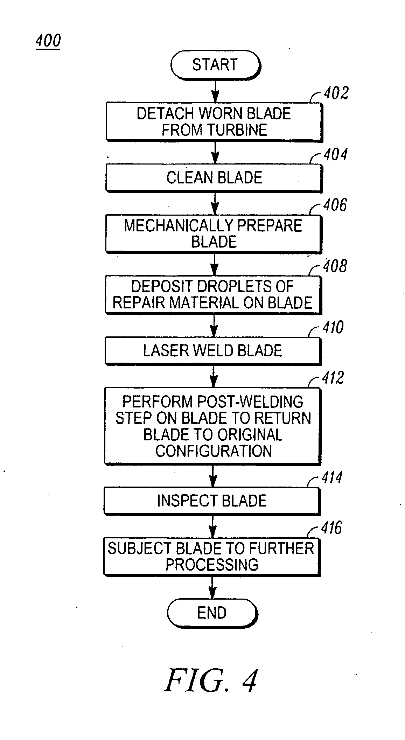

At times, the blade 100 may become worn and may need to be repaired. Turning now to FIG. 4, a flow diagram is provided showing an exemplary method 400 for repairing the turbine blade 100. Although the following method is described with reference to repair of a turbine blade, it should be understood that the method is in no way limited to blades, and may be used to repair other components that are thin-walled.

When one or more worn or degraded turbine blades are identified after an incoming inspection, they are typically detached from a turbine, step 402. Next, the blade 100 is cleaned, step 404. For example, step 404 may include chemical cleaning, such as chemical degreasing and stripping a coating from the blade 100. The turbine blade 100 may further be mechanically prepared as well, step 406. In such case, the step of mechanically preparing a turbine blade 100 can include one or more processes including pre-repair machining and degreasing the surface to be repaired in order to remove any oxidation and dirt or other materials. It will be appreciated that the present embodiment is not limited to these preparatory steps, and that additional, or different types and numbers of preparatory steps can be conducted.

Next, droplets of repair material are deposited onto a damaged section of the blade, step 408, such as, for example, on a damaged thin-walled section of the blade. Preferably, the droplets are sized small enough such that when they contact the blade, heat emitted from the droplets does not distort the blade wall shape. In accordance with the invention, electro-spark deposition is employed. In this regard, an electrode comprising the repair material is contacted with the damaged wall of the blade 100. The blade 100 is grounded, and an arc discharge current is passed between the electrode and the blade. The arc discharge current melts a portion of the electrode into individual droplets transferring the droplets to the grounded blade surface to form an intermediate layer thereon. Because the individual droplets are extremely small and the overall mass transfer rate of material is small, the heat input to the blade is very low. The repair material is preferably a material that is substantially similar to the blade base material. For example, in one embodiment, the turbine blade is made of a single crystal superalloy, and the repair material is a similar material having equivalent or improved mechanical properties and excellent oxidation resistance over those of the single crystal superalloy. However, other suitable repair materials that may improve overall properties of the blade may alternatively be used.

After the intermediate layer is suitably formed, the blade 100 is laser welded, step 410. Laser welding process re-melts the intermediate layer instead of the underlying original blade material, thereby forming a deposit where damage to the airfoils of the blade 100 or its cooling passages is minimized. Advantageously, re-melting the intermediate layer improves its integrity by minimizing porosity. Laser welding also allows for the deposit of additional repair material onto the re-melted intermediate layer thereby thickening the blade wall. The additional repair material is incorporated into the re-melted intermediate layer to form a build up layer in significantly less time than can be achieved by electro-spark deposition alone. Any one of numerous laser welding techniques and laser welding equipment may be used. For example, in instances in which a localized portion of the blade 100 is to be welded, a hand-held laser may be used. In other circumstances, an automated laser welding system may be employed. The additional repair material may be the same material as the repair material of step 408 and/or the base material, and may be, for example, a welding repair superalloy; or, alternatively, the additional repair material and the step 408 repair material may be substantially identically formulated. The additional repair material may be supplied in any form customarily used in laser welding including powder and wire.

Returning to the flow diagram of FIG. 4, after the laser welding step 410 is completed at least one post-weld step 412 is performed depending on the type of repair that was performed. For example, post-welding steps may include processes that improve the turbine component's mechanical properties, and metallurgical integrity. For example, processes that include final machining the repaired components to a predetermined design dimension may be performed.

After the post-welding process step 412 is completed, at least one inspection process can be performed as step 414 to determine whether any surface defects exist, such as cracks or other openings. An inspection process can be conducted using any well-known non-destructive inspection techniques including, but not limited to, a fluorescent penetration inspection ("FPI inspection"), and a radiographic inspection. If the repaired components pass an inspection, and they may be subjected to further processing, step 416. Further processes may include re-coating blades with a suitable material such as environment-resistant diffusion aluminide and/or MCrAlY overlay coatings, coating diffusion and aging heat treatments. Then, a final inspection is performed on the repaired components. If the repaired components pass the final inspection, they are ready for use.

While the invention has been described with reference to a preferred embodiment, it will be understood by those skilled in the art that various changes may be made and equivalents may be substituted for elements thereof without departing from the scope of the invention. In addition, many modifications may be made to adapt to a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A method (400) of repairing a degraded section of a turbine blade (100), the turbine blade (100) comprising a base material, the method **characterized by** the steps of:
electro-spark depositing (408) a first material on the turbine blade degraded section to form an intermediate layer thereon, the first material comprising a material that is substantially similarly or is more corrosion resistant and oxidation resistant than the base material; and
laser welding (410) a second material onto the intermediate layer to form a repaired section.

2. The method of claim 1, further comprising:
machining (412) the repaired section to an original blade configuration.

3. The method of claim 1, further comprising:
cleaning (404) the turbine blade before the step of electro-spark depositing.

4. The method of claim 1, further comprising:
coating (416) the turbine blade with an environment-resistant material, after the steps of electro-spark depositing and laser welding.

5. The method of claim 4, further comprising:
heat treating (416) the turbine blade, after the steps of electro-spark depositing, laser welding, and coating.

6. The method of claim 1, wherein the first and the second materials are substantially identically formulated.

7. The method of claim 1, wherein the step of laser welding (410) comprises laser powder fusion welding.

8. The method of claim 1, wherein the step of laser welding (410) comprises using a hand-held laser powder fusion welding system.

9. The method of claim 1, wherein the step of electro-spark depositing (408) comprises:
grounding the blade;
contacting the blade with an electrode comprising the first material; and
passing a current between the electrode and the grounded blade.

10. The method of claim 1, wherein the base material, the first material, and the second material comprise a nickel-based superalloy.

## Patentansprüche

1. Verfahren (400) zur Reparatur eines beeinträchtigten Abschnitts einer Turbinenschaufel (100), wobei die Turbinenschaufel (100) ein Basismaterial umfasst, wobei das Verfahren durch die folgenden Schritte **gekennzeichnet** ist:
Elektrofunkenabscheidung (408) eines ersten Materials auf einen beeinträchtigten Turbinenschaufelabschnitt zur Bildung einer Zwischenschicht darauf, wobei das erste Material ein Material umfasst, das dem Basismaterial im Wesentlichen ähnelt oder korrosionsbeständiger und oxidationsbeständiger als dieses ist; und
Laserschweißen (410) eines zweiten Materials auf die Zwischenschicht zur Bildung eines reparierten Abschnitts.

2. Verfahren nach Anspruch 1, das weiterhin
Bearbeiten (412) des reparierten Abschnitts zu einer ursprünglichen Schaufelkonfiguration umfasst.

3. Verfahren nach Anspruch 1, das weiterhin
Reinigen (404) der Turbinenschaufel vor dem Schritt der Elektrofunkenabscheidung umfasst.

4. Verfahren nach Anspruch 1, das weiterhin
Beschichten (416) der Turbinenschaufel mit einem gegen Umwelteinflüsse beständigen Material nach den Schritten der Elektrofunkenabscheidung und des Laserschweißens umfasst.

5. Verfahren nach Anspruch 4, das weiterhin
Wärmebehandeln (416) der Turbinenschaufel nach den Schritten der Elektrofunkenabscheidung, des Laserschweißens und des Beschichtens umfasst.

6. Verfahren nach Anspruch 1, wobei das erste und das zweite Material im Wesentlichen identisch formuliert sind.

7. Verfahren nach Anspruch 1, wobei der Schritt des Laserschweißens (410) Laserpulverschmelzschweißen umfasst.

8. Verfahren nach Anspruch 1, wobei der Schritt des Laserschweißens (410) Verwenden eines in der Hand gehaltenen Laserpulverschmelzschweißsystems umfasst.

9. Verfahren nach Anspruch 1, wobei der Schritt der Elektrofunkenabscheidung (408):
Erden der Schaufel,
Kontaktieren der Schaufel mit einer das erste Material umfassenden Elektrode und
Leiten eines Stroms zwischen der Elektrode und der geerdeten Schaufel umfasst.

10. Verfahren nach Anspruch 1, wobei das Basismaterial, das erste Material und das zweite Material eine auf Nickel basierende Superlegierung umfassen.

## Revendications

1. Procédé (400) de réparation d'une section dégradée d'une pale de turbine (100), la pale de turbine (100) comprenant une matière de base, le procédé étant **caractérisé par** les étapes suivantes:
déposer par électroérosion (408) une première matière sur la section dégradée de la pale de turbine pour former une couche intermédiaire sur celle-ci, la première matière comprenant une matière qui est sensiblement aussi ou plus résistante à la corrosion et résistante à l'oxydation que la matière de base; et
souder au laser (410) une deuxième matière sur la couche intermédiaire pour former une section réparée.

2. Procédé selon la revendication 1, comprenant en outre l'usinage (412) de la section réparée à une configuration de pale originale.

3. Procédé selon la revendication 1, comprenant en outre le nettoyage (404) de la pale de turbine avant l'étape de dépôt par électroérosion.

4. Procédé selon la revendication 1, comprenant en outre le revêtement (416) de la pale de turbine avec une matière qui résiste à l'environnement, après les étapes de dépôt par électroérosion et de soudage au laser.

5. Procédé selon la revendication 4, comprenant en outre un traitement thermique (416) de la pale de turbine après les étapes de dépôt par électroérosion, de soudage au laser et de revêtement.

6. Procédé selon la revendication 1, dans lequel les première et deuxième matières sont formulées de façon sensiblement identique.

7. Procédé selon la revendication 1, dans lequel l'étape de soudage au laser (410) comprend un soudage par fusion de poudre au laser.

8. Procédé selon la revendication 1, dans lequel l'étape de soudage au laser (410) comprend l'utilisation d'un système manuel de soudage par fusion de poudre au laser.

9. Procédé selon la revendication 1, dans lequel l'étape de dépôt par électroérosion (408) comprend les étapes suivantes:
mettre la pale à la terre;
mettre la pale en contact avec une électrode qui comprend la première matière; et
faire passer un courant entre l'électrode et la pale mise à la terre.

10. Procédé selon la revendication 1, dans lequel la matière de base, la première matière et la deuxième matière comprennent un superalliage à base de nickel.
